(19) Europäisches Patentamt / European Patent Office / Office européen des brevets

(11) **EP 2 131 497 B1**

(12) **EUROPÄISCHE PATENTSCHRIFT**

(45) Veröffentlichungstag und Bekanntmachung des Hinweises auf die Patenterteilung:
**02.05.2012 Patentblatt 2012/18**

(51) Int Cl.:
**H03K 17/082** (2006.01)

(21) Anmeldenummer: **08010198.3**

(22) Anmeldetag: **04.06.2008**

(54) **Halbleiterschalter mit Kurzschlussabschaltung**

Semi-conductor switch with short-circuit switch off

Commutateur de semi-conducteur doté d'une commutation de court-circuit

(84) Benannte Vertragsstaaten:
**DE ES FR GB IT**

(43) Veröffentlichungstag der Anmeldung:
**09.12.2009 Patentblatt 2009/50**

(73) Patentinhaber: **Eberspächer Controls GmbH & Co. KG**
**76863 Herxheim (DE)**

(72) Erfinder: **Wandres, Steffen**
**76870 Kandel (DE)**

(74) Vertreter: **Grünecker, Kinkeldey, Stockmair & Schwanhäusser**
**Leopoldstrasse 4**
**80802 München (DE)**

(56) Entgegenhaltungen:
**EP-A- 0 599 455          EP-A- 1 176 685**
**US-A1- 2004 207 967**

**Beschreibung**

Die vorliegende Erfindung bezieht sich auf Halbleiterschalter zum Schalten des Laststroms eines elektrischen Verbrauchers und insbesondere auf Halbleiterschalter mit einer integrierten Überwachungsschaltung zum Schutz vor Überstrom und Kurzschluss.

In vielen Bereichen haben Halbleiterschalter aufgrund ihrer hervorragenden Schalteigenschaften herkömmliche elektromechanische Relais verdrängt. Die heutigen Halbleiterschalter bestehen zumeist aus einem Leistungs-MOSFET zum Schalten des Laststroms sowie einer integrierten Steuer- und Überwachungsschaltung und werden von diversen Herstellern unter den Bezeichnungen Smart Power Mosfets, Intelligent Power Switch bzw. IPS, Profet, IntelliMAX u.a. angeboten.

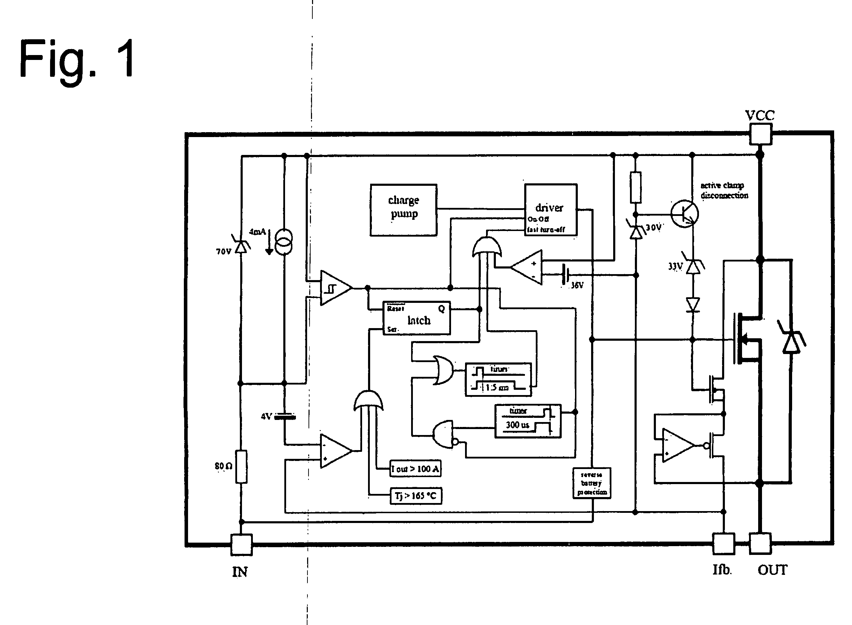

Halbleiterschalter, die sich zum Schalten der positiven Versorgungsspannung eines Verbrauchers eignen, werden üblicherweise als Highside-Schalter bezeichnet. Die Steuer- und Überwachungsschaltung dieser Schalter beinhaltet eine Ladungspumpe zur Erzeugung einer ausreichend hohen Ansteuerspannung, welche erforderlich ist, um den N-Kanal Leistungs-MOSFET durchsteuern zu können. Da es sich hierbei um reine Schalttransistoren handelt, die statisch nur die Zustände Ein oder Aus einnehmen dürfen, ist es unerwünscht, dass diese in den Linearbetrieb, also einen nicht vollständig ein- oder ausgeschalteten Zustand gelangen. Daher besitzen diese Bausteine eine Unterspannungserkennung, die den MOSFET gezielt abschaltet, sobald die Versorgungsspannung nicht mehr zum sicheren Betrieb der Ladungspumpe ausweicht. Daneben besitzen diese Bausteine aber auch Schutzmechanismen, die den MOSFET bei Überstrom oder Kurzschluss abschalten. Weiterhin besitzen diese Bausteine auch einen Reverse-Battery-Schutz, der den MOSFET bei einer Verpolung der Betriebsspannung (VCC-Pin negativ gegenüber Masse) invers leitend werden lässt. Ein mögliches Blockschaltbild eines solchen Bausteines ist in Fig. 1 dargestellt.

Die Unterspannungsabschaltung schaltet den MOSFET aus, sobald die Betriebsspannung VCC einen bestimmten Wert Uuv unterschreitet. Wenn die Versorgungsspannung VCC wieder ansteigt und einen bestimmten Wert (mit geeigneter Hysterese zum Abschaltwert) überschritten hat, wird der MOSFET wieder eingeschaltet.

Neben der Unterspannungsabschaltung ist auch noch ein Mechanismus zum Zurücksetzen der gesamten Schaltung in einen definerten Ausgangszustand vorgesehen. Ein derartiger RESET der gesamten Schaltung erfolgt bei einem Absinken der Betriebsspannung VCC unter eine Spannung $U_{RS}$, die unter der Unterspannungsabschaltschwelle Uuv liegt, $U_{RS}$ < Uuv. Sobald die Versorgungsspannung VCC wieder ansteigt und einen bestimmten Wert (mit geeigneter Hysterese zum Abschaltwert) überschritten hat, wird die Schaltung wieder aktiv.

Die Überstrom- bzw. Kurzschluss-Abschaltung schaltet oberhalb eines bestimmten Laststromes den MOSFET aus, um ihn vor einer Überlastung zu schützen. Außerdem wird in diesem Fall der Zustand "Überstrom/Kurzschtuss" in einem Speicherelement (Flipflop) gespeichert, um ein selbsttätiges Einschalten, wenn der Laststrom wieder sinkt, zu verhindern. Nach einer erfolgten Überstrom- bzw. Kurzschluss-Abschaltung kann der integrierte Halbleiterschalter erst durch ein definiertes Aus- und Einschalten wieder in Betrieb genommen werden.

Anwendungen für derartige Halbleiterschalter finden sich beispielsweise im Kfz-Bereich, bei denen elektrische Gleichstromverbraucher wie z.B. Leuchten und Aktuatoren mit Lastströmen in der Gößenordnung von 1...10A geschaltet werden müssen. Höhere Anforderungen an die Stromtragfähigkeit des Halbleiterschalters bestehen beispielsweise bei elektrischen Zusatzheizungen, die Leistungen von einigen kW aufweisen können, so dass zu Steuerung derartiger Heizvorrichtungen bei Bordspannungen von 10...500V Ströme von einigen 10...100A geschaltet werden müssen. Die Anforderungen hinsichtlich maximaler Schaltspannung (10...500V) und Schaltfrequenz (0...100Hz) sind dabei in den meisten Fällen vergleichsweise gering.

Der oben beschriebene herkömmliche Schutzmechanismus vor Überstrom und Kurzschluss kann unter Umständen versagen, vorallem beim Schalten großer Ströme (einige 10A bis 100A) und wenn die Zuleitung der Versorgungsspannung eine merkliche Induktivität von einigen $\mu$H aufweist. Dieses Problem betrifft insbesondere die Kfz-Elektrik, bei der elektrische Verbraucher häufig durch einen ausgedehnten Kabelbaum von der Stromquelle (Generator oder Batterie) getrennt sind. Dabei kann es im Falle eines Kurzschlusses, hervorgerufen durch den induktiven Widerstand der Leitungsinduktivität, zu einem Einbruch der Versorgungsspannung VCC am Betriebsspannungsanschluss (VCC-Pin) des integrierten Halbleiterschalters kommen. Sinkt dabei die Versorgungsspannung VCC unter die RESET-Abschaltschwelle $U_{RS}$, so führt der Baustein einen RESET aus und löscht das Speicherelement. Der Zustand "Überstrom/Kurzschluss" kann somit nicht gespeichert werden. Dies hat zur Folge, dass es sofort nach dem Abschalten zu einem erneuten Einschalten kommt. Besteht der Kurzschluss weiter, wiederholt sich derselbe Zyklus erneut. Der Baustein wird hierdurch extrem belastet, da er bei jedem Schaltzyklus eine Energie von

$$E = 1/2 * I_L * L/R_L * (VCC + |Vout|) * \ln(1 + (I_L * R_L)/(|Vout|))$$

in Wärme umsetzen muss, wobei $I_L$ = Last / Kurzschlussstrom, L= Leitungsinduktivität, $R_L$ = Lastwiderstand, VCC= Spannung am Drain (VCC-Pin), |Vout|= Betrag der Spannung am Source (Out-Pin).

Im Kurzschlussfall wäre daher ein dauerhaftes Abschalten, bei dem ein Wiedereinschalten erst durch ein definiertes Wegnehmen des Einschaltsignals am Steueranschluss IN/GND erfolgt, wünschenswert. Zu diesem Zweck wird der integrierte Halbleiterschalter daher üblicherweise mit einem Mikrocontroller überwacht, der bei Erkennung eines Kurzschlusses die Ansteuerung des Transistors abschaltet. Dies ist jedoch mit einem großen schaltungstechnischen Aufwand verbunden.

Aus der Druckschrift EP 0 599 455 A2 ist eine Überstromschutzschaltung für einen Leistungstransistor bekannt. Diese Schutzschaltung enthält einen Stromdetektor, der ein Spannungssignal erzeugt, das die Größe des durch den Leistungstransistor fließenden Stroms angibt. Überschreitet dieser Strom eine vorgegebene Schwelle, so wird durch die Schutzschaltung zunächst ein weiterer Anstieg des Stroms verhindert, bevor er bei einem Fortbestehen des Kurzschlusses nach einer vorgegebenen Zeit ganz abgeschaltet wird. Aus dieser Druckschrift ist auch eine "Halteschaltung" bekannt, die ein am Steuereingang des Leistungstransistor angelegtes Pulsbreitenmodulationssignal im Kurzschlussfall so lange auf dem "Ein"-Pegel hält, bis die kontrollierte Abschaltung des Leistungstransistors erfolgt ist.

Aus den Druckschriften EP 1 176 685 A1 und US 2004/0207967 sind ebenfalls Halbleiterschalter mit Überstromschutzschaltung bekannt. Diese Schutzschaltung beinhaltet eine Referenzstromquelle, die den transienten Stromverlauf beim Einschalten der Last nachbildet. Ein Komparator vergleicht den Strom durch den Leistungs-FET mit dem Referenzstrom, um einen gegebenenfalls vorliegenden Kurzschluss zu detektieren und den Leistungs-FET abzuschalten. Nach erfolgter Abschaltung wird der Halbleiterschalter mit einer gewissen Verzögerungszeit erneut eingeschaltet, wobei ein Zähler und eine Speichereinheit vorgesehen sind, um den Halbleiterschalter nach einer vorgegebenen Zahl von Einschaltversuchen permanent abzuschalten.

Bei den herkömmlichen Halbleiterschaltern mit Überstromschutzschaltung können jedoch Probleme auftreten, wenn aufgrund eines Kurzschlusses die Spannungsversorgung vorübergehend zusammenbricht und der in der Speichereinheit gespeicherte Zustand verloren geht.

Ziel der vorliegenden Erfindung ist es daher, einen elektronischen Schalter mit verbesserter Kurzschlussabschaltung anzugeben.

Dies wird durch die Merkmale des unabhängigen Anspruchs erreicht. Bevorzugte Ausführungsformen sind Gegenstand der abhängigen Ansprüche.

Es ist der besondere Ansatz der vorliegenden Erfindung, eine Zusatzbeschaltung vorzusehen, die das Potential des Masseanschlusses des integrierten Halbleiterschalters bei einem Einbruch der Betriebsspannung auf einen Wert unterhalb des Massepotentials zieht, um so sicherzustellen, dass zwischen dem Betriebsspannungsanschluss und dem Masseanschluss eine Spannung anliegt, die ausreicht, um den Zustand "Überstrom/Kurzschluss" zu speichern und somit ein Wiedereinschalten zu verhindern.

Gemäß einem ersten Aspekt der vorliegenden Erfindung wird ein elektronischer Schalter zum Schalten des Laststroms eines elektrischen Gleichstromverbrauchers mit den Merkmalen des Anspruchs 1 zur Verfügung gestellt.

Der elektronische Schalter umfasst einen Steuersignaleingang, wobei der elektronische Schalter in Abhängigkeit von einem an dem Steuersignaleingang angelegten Steuersignal und dem in der Speichereinrichtung gespeicherten Detektionsergebnis geöffnet und geschlossen wird. Auf diese Weise kann der elektronische Schalter nach der Detektion eines Kurzschlusses oder eines Überstroms aus Sicherheitsgründen abgeschaltet bleiben, auch wenn am Signaleingang weiterhin das EIN-Signal anliegt.

Vorzugsweise verbindet die Zusatzbeschaltung den Masseanschluss des integrierten Halbleiterschalters mit Masse. Bei einem integrierten Halbleiterschalter, dessen Masse und Steuereingang am selben Anschluss herausgeführt werden, verbindet die Zusatzbeschaltung den Masseanschluss des integrierten Halbleiterschalters aber vorteilhafterweise mit dem Steuersignaleingang des elektronischen Schalters.

Vorteilhafterweise ist die Zusatzbeschaltung so ausgelegt, dass der Spannungsabfall über die Zusatzbeschaltung im Normalbetrieb im Wesentlichen 0 Volt beträgt. In diesem Fall beeinträchtigt die Zusatzbeschaltung die Stromversorgung des integrierten Halbleiterschalters in keiner Weise.

Vorteilhafterweise ist die Zusatzbeschaltung so ausgelegt, dass der Spannungsabfall über die Zusatzbeschaltung bei einem Einbruch der Spannung am Betriebsspannungsanschluss des integrierten Halbleiterschalterbausteins im Wesentlichen der Betriebsspannung im Normalbetrieb entspricht. In diesem Fall bleibt die Stromversorgung des integrierten Halbleiterschalters auch während des Einbruchs der Spannung am Betriebsspannungsanschluss gewährleistet.

Vorzugsweise wird die Zusatzbeschaltung durch einen Ohmschen Widerstand gebildet. Dadurch wird eine besonders einfache und kostengüstige Realisierung der vorliegenden Erfindung erreicht.

Vorteilhafterweise wird die Zusatzbeschaltung durch eine im Normalbetrieb in Durchlassrichtung geschaltete Diode (D1) oder durch einen Transistor, der im Normalbetrieb durchgesteuert ist und bei einem Einbruch der Spannung am Betriebsspannungsanschluss sperrt, gebildet. Dadurch wird der Entladestrom des Stützkondensators reduziert, woraus sich die Möglichkeit ergibt, auch länger andauernde Spannungseinbrüche zu überbrücken.

Vorteilhafterweise enthält der integrierte Halbleiterschalterbaustein zusätzlich eine Schutzschaltung gegen Verpolung, wobei der Masseanschluss des integrierten Halbleiterschalterbausteins zusätzlich über eine Reihenschaltung aus einem Ohmschen Widerstand und einer im Normalbetrieb in Sperrrichtung geschalteten Diode mit Masse verbunden ist. Auf diese Weise kann die Schutzschaltung gegen Verpolung im Falle einer Verpolung der Betriebsspannung den integrierten Halbleiterschalter einschalten, um eine Überhitzung oder gar eine Zerstörung aufgrund der durch den Spannungsabfall über der Body-Diode des MOSFET erzeugten Verlustleistung zu verhindern.

Gemäß einem weiteren Aspekt der vorliegenden Erfindung wird ein Kraftfahrzeugbordnetz mit einer Stromquelle, einem mit der Stromquelle verbundenen Kabelbaum und einem elektrischen Verbraucher zur Verfügung gestellt, wobei der elektrische Verbraucher über einen erfindungsgemäßen elektronischen Schalter an einem bezüglich der Stromquelle entgegengesetzten Ende des Kabelbaums angeschlossen ist.

Die Erfindung wird im folgenden unter Bezugnahme auf die beigefügten Abbildungen beschrieben, in denen:

Fig. 1    ein Blockschaltbild eines herkömmlichen Smart-Power-Highside- Schalters zeigt,

Fig. 2    ein Schaltungsdiagramm für einen elektronischen Schalter gemäß einer ersten beispielhaften Ausführungsform der vorliegenden Erfindung zeigt,

Fig. 3    ein Schaltungsdiagramm für einen elektronischen Schalter gemäß einer zweiten Ausführungsform der vorliegenden Erfindung zeigt,

Fig. 4    ein Schaltungsdiagramm für einen elektronischen Schalter gemäß einer dritten Ausführungsform der vorliegenden Erfindung zeigt,

Fig. 5    ein Schaltungsdiagramm für einen elektronischen Schalter gemäß einer vierten Ausführungsform der vorliegenden Erfindung zeigt,

Fig. 6    ein Schaltungsdiagramm für einen elektronischen Schalter gemäß einer fünften Ausführungsform der vorliegenden Erfindung zeigt, und

Fig. 7    ein Schaltungsdiagramm für einen elektronischen Schalter gemäß einer sechsten Ausführungsform der vorliegenden Erfindung zeigt.

Im folgenden werden die einzelnen Ausführungsformen der vorliegenden Erfindung detailliert beschrieben.

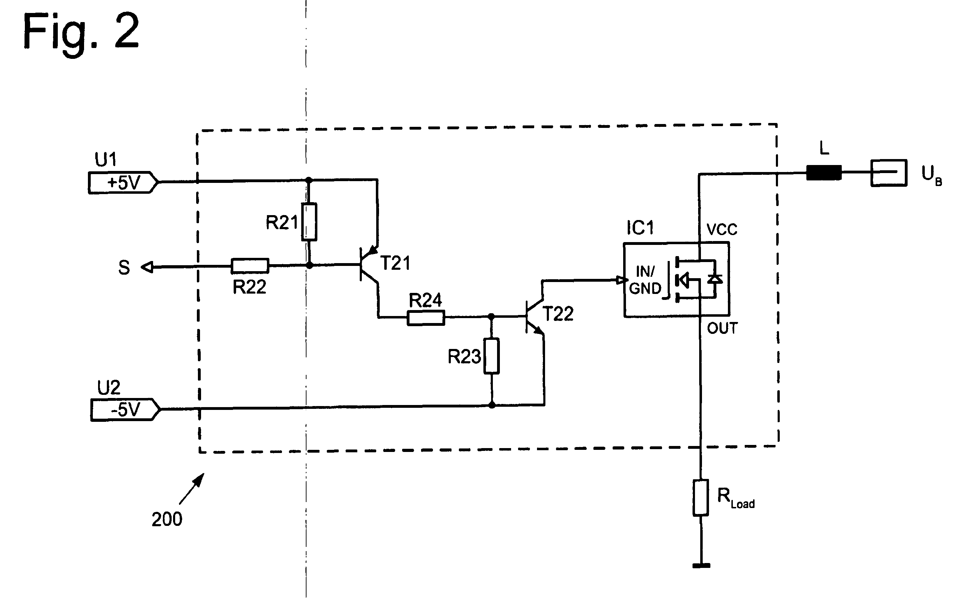

Fig. 2 ist ein Schaltungsdiagramm für einen elektronischen Schalter 200 gemäß einer ersten beispielhaften Ausführungsform der vorliegenden Erfindung. In diesem Schaltungsdiagramm ist eine Last ($R_{Load}$), bzw. ein elektrischer Gleichstromverbraucher, über einen integrierten Halbleiterschalter IC1 mit der Betriebsspannung $U_B$ verbunden. Die Betriebsspannung kann dabei in Form einer Gleichspannung durch eine Batterie, einen Akkumulator, einen Kondensator oder dergleichen zur Verfügung gestellt werden. Die Induktivität der Zuleitung, die z.B. Teil eines Kabelbaums sein kann, wird durch L repräsentiert. Der integrierte Halbleiterschalter IC1 besitzt neben den Schaltanschlüssen VCC und OUT einen LOW-aktiven Steuereingang IN/GND. "LOW-aktiv" bedeutet, dass der Halbleiterschalter durch Anlegen des Logikpegels "LOW" eingeschaltet und durch Anlegen des Logikpegels "HIGH" ausgeschaltet wird.

Bei einem integrierten Halbleiterschalter mit LOW-aktivem Steuereingang kann der Steuereingang zugleich die Funktion des Masseanschlusses übernehmen, da die integrierte Steuer- und Überwachungsschaltung über den mit der positiven Betriebsspannung verbundenen Anschluss VCC und den im eingeschalteten Zustand auf Masse gelegten Steuereingang IN/GND mit Strom versorgt werden kann. Im ausgeschalteten Zustand (Steuereingang IN/GND auf logisch HIGH, bzw. offen) ist die integrierte Steuer- und Überwachungsschaltung stromlos.

Wenn im eingeschalteten Zustand ein Kurzschluss oder Überstrom detektiert wird, kann die Überwachungsschaltung den MOSFET abschalten und den Zustand "Kurzschluss" in dem Flipflop speichern. Der Speicherinhalt des Flipflops bleibt dann solange erhalten, wie die integrierte Steuer- und Überwachungsschaltung mit Strom versorgt wird, d.h. solange wie der Steuereingang auf LOW-Pegel liegt. Erst eine kontrollierte Wegnahme des externen Steuersignals (Steuereingang auf HIGH) führt zu einem Reset des Bausteins, bzw. zum Löschen des Flipflops.

Gemäß der ersten Ausführungsform der vorliegenden Erfindung wird mit Hilfe zweier (externer) Transistoren T21 und T22 und einer biploren Spannungsversorgung U1 und U2, z.B. U1 = +5 V und U2 = -5 V, das Spannungsniveau am SteuersignalEingang IN/GND des integrierten Halbleiterschalters IC1 um den Betrag der Spannung U2 unter das Masse-Niveau (GND) abgesenkt. Zum Einschalten des elektronischen Schalters 200 wird das Steuersignal S auf Masse gelegt. Dadurch wird der Transistor T21 und infolge der Transistor T22 durchgeschaltet. Dadurch wiederum sinkt das Potential am Steuersignaleingang IN/GND des integrierten Halbleiterschalters IC1 auf U2 und der Halbleiterschalter wird eingeschaltet. Zum Ausschalten des elektronischen Schalters 200 wird das Steuersignal S auf logisch HIGH gelegt, so dass beide Transistoren T21 und T22 sperren. Der Steuersignaleingang IN/GND des integrierten Halbleiterschalters IC1 ist somit offen (logisch HIGH) und der Halbleiterschalter sperrt.

Sinkt nun bei eingeschaltetem Halbleiterschalter (S = LOW) die Betriebsspannung $U_B$ bis auf Masse-Potential, also 0 V, ab, so verbleibt zwischen den Anschlüssen IN/GND und VCC immer noch eine Spannungsdifferenz in Höhe der Spannung U2. Dies reicht aus, um die interne Steuerschaltung und insbesondere das interne Speicherelement des integrierten Halbleiterschalters IC1 mit Strom zu versorgen. Wurde der Spannungseinbruch durch einen Kurzschluss im Lastkreis des Halbleiterschalters hervorgerufen, so bleibt der als erstes erkannte Zustand "Kurzschluss" gespeichert und ein Wiedereinschalten des Halbleiterschalters nach dem Spannungseinbruch wird verhindert.

Im Falle eines Kurzschlusses wird der erfindungsgemäße Halbleiterschalter daher dauerhaft abgeschaltet, selbst wenn durch den Kurzschluss ein vorübergehender Spannungszusammenbruch ausgelöst wird. Ein periodisches Wiedereinschalten "in den Kurzschluss hinein" wird zuverlässig verhindert, die thermische Belastung des integrierten Halbleiterschatters verringert und die Lebensdauer-dementsprechend verlängert.

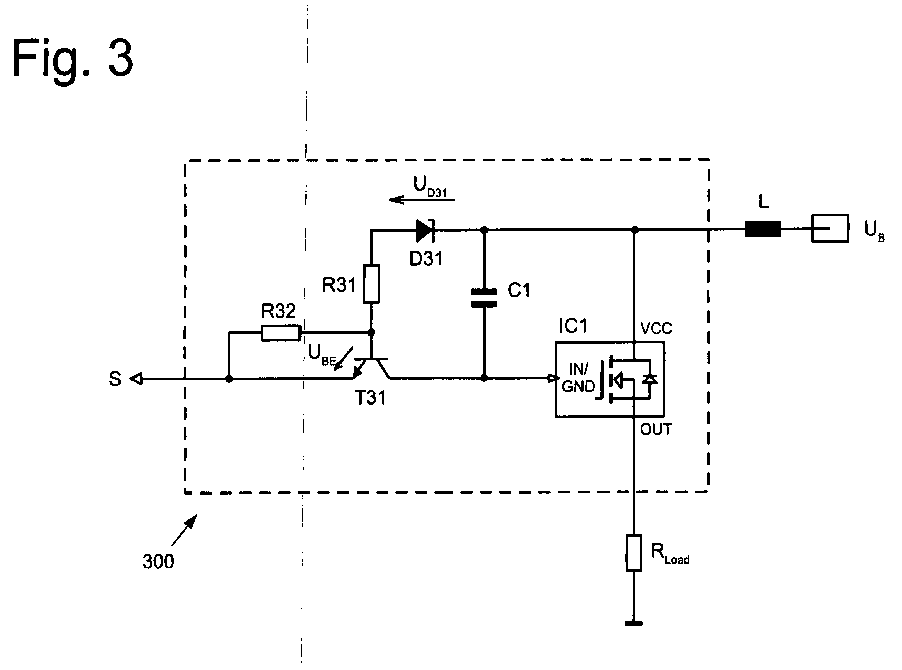

Fig. 3 ist ein Schaltungsdiagramm für einen elektronischen Schalter 300 gemäß einer zweiten Ausführungsform der vorliegenden Erfindung. Die zweite Ausführungsform ähnelt der in Fig. 2 gezeigten ersten Ausführungsform, wobei äquivalente Komponenten mit den gleichen Bezugszeichen gekennzeichnet sind und auf eine Wiederholung der entsprechenden Erläuterung verzichtet wird.

Im Unterschied zur ersten Ausführungsform kommt die zweite Ausführungsform ohne zusätzliche Versorgungsspannungen aus und stellt die Versorgungsspannung des Halbleiterschalters während eines Spannungseinbruchs mit Hilfe eines Stützkondensators zur Verfügung. Der Stützkondensator C1 ist dabei zwischen dem Betriebsspannungsanschluss VCC und dem LOW-aktiven Steuereingang IN/GND des integrierten Halbleiterschalters IC1 vorgesehen.

Zum Einschalten des elektronischen Schalters 300 wird das Steuersignal S auf Masse gelegt. Dadurch wird auch der Steuersignaleingang IN/GND des integrierten Halbleiterschalters IC1 auf Masse-Potential gezogen, da der Transistor T31, angesteuert durch den Widerstand R31 und die Z-Diode D31, durchgesteuert ist. Der Basisstrom und damit die zum Durchsteuern von T31 erforderliche Basis-Emitter-Spannung wird durch R31 und D31 aus der Versorgungsspannung $V_B$ erzeugt. Der Kondensator C1 lädt sich auf die Spannung am Anschluss VCC auf, da der untere Anschluss von C1 bei durchgeschaltetem T31 auf Masse-Potential liegt.

Bei einem Einbruch der Betriebsspannung des Halbleiterschalters sperrt der Transistor T31, sobald die Spannung am Anschluss VCC unter eine Spannung von etwa $U_{D31} + U_{BE}$ abgesunken ist. Typische Wert für $U_{D31}$ und $U_{BE}$ sind $U_{D31}$ : 5 V bis 10 V und $U_{BE}$ : ca. 0,7 V.

Der Kondensator C1 ist zum Zeitpunkt des Abschaltens von T31 auf die Spannung $U_{D31} + U_{BE}$ aufgeladen und hält somit die Spannung zwischen den Anschlüssen IN/GND und VCC auf diesem Wert, da der Anschluss IN/GND durch den gesperrten Transistor T31 nicht mehr mit Masse verbunden ist. Diese Spannung reicht aus, um die interne Steuerschaltung des integrierten Halbleiterschalters IC1 zu versorgen. Wurde der Spannungseinbruch durch einen Kurzschluss im Lastkreis des Halbleiterschalters hervorgerufen, so bleibt der als erstes erkannte Zustand "Kurzschluss" gespeichert und ein Wiedereinschalten des Halbleiterschalters nach dem Spannungseinbruch wird verhindert.

Der Kondensator C1 wird durch den Betriebsstrom des Halbleiterschalters IC1, der in den Anschluss IN/GND hineinfließt entladen; infolge dessen sinkt die Spannung des Kondensators und damit die Spannung zwischen den Anschlüssen VCC und IN/GND ab. Die Stromversorgung des integrierten Halbleiterschalters ist daher nur während kurzzeitiger Spannungseinbrüche, hervorgerufen durch einen Kurzschluss in Verbindung mit der Leitungsinduktivität, sichergestellt, was aber in vielen Anwendungen ausreichend ist.

Auch gemäß der zweiten Ausführungsform wird daher im Falle eines Kurzschlusses der Halbleiterschalter dauerhaft abgeschaltet, selbst wenn durch den Kurzschluss ein vorübergehender Spannungszusammenbruch ausgelöst wird. Ein periodisches Wiedereinschalten "in den Kurzschluss hinein" wird zuverlässig verhindert, die thermische Belastung des integrierten Halbleiterschalters verringert und die Lebensdauer dementsprechend verlängert. Darüberhinaus benötigt der elektronische Schalter gemäß der zweiten Ausführungsform keine zusätzlichen Versorgungsspannungen U1 und U2, die nicht in allen Anwendungen zur Verfügung stehen. Besonders die negative Versorgungsspannung U2 kann meist nur aufwendig mit einem Spannungsinverter erzeugt werden. Außerdem wird im Vergleich zur ersten Ausführungsform die maximale Betriebsspannung des Halbleiterschalters (bezogen auf Masse) am Anschluss VCC nicht um die Spannung U2 reduziert.

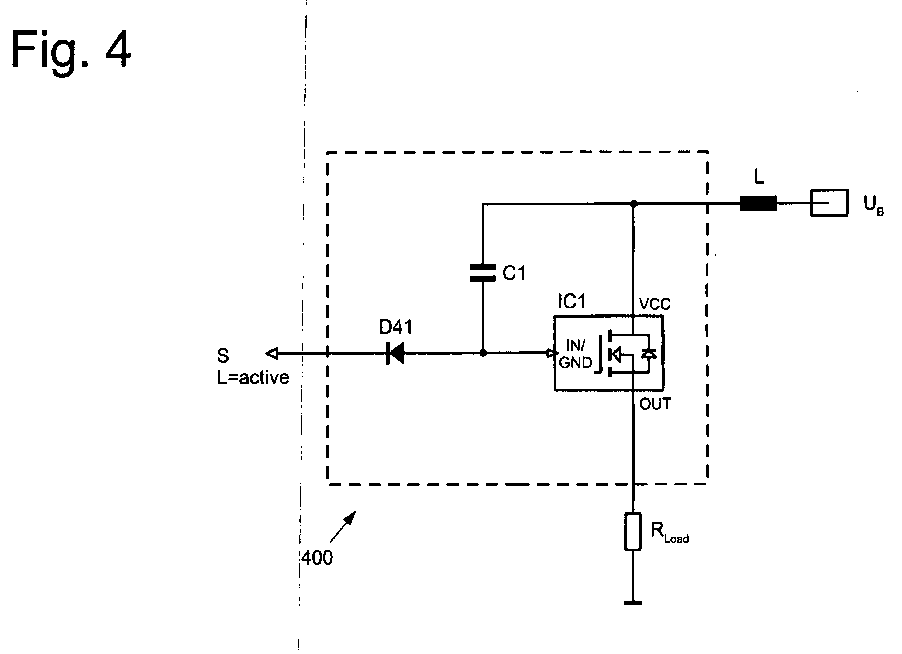

Fig. 4 ist ein Schaltungsdiagramm für einen elektronischen Schalter 400 gemäß einer dritten Ausführungsform der vorliegenden Erfindung. Die dritte Ausführungsform ähnelt der in Fig. 3 gezeigten zweiten Ausführungsform, wobei äquivalente Komponenten mit den gleichen Bezugszeichen gekennzeichnet sind und auf eine Wiederholung der entsprechenden Erläuterung verzichtet wird.

Die dritte Ausführungsform zeichnet sich durch eine besonders geringe Zahl zusätzlich erforderlicher Bauelemente aus. Wie aus Fig. 4 ersichtlich, besteht die externe Beschaltung des integrierten Halbleiterschalters IC1 lediglich aus dem Stützkondensator C1 und einer Diode D41, die den Signaleingang des elektronischen Schalters 400 mit dem Signaleingang des integrierten Halbleiterschalters IC1 verbindet, wobei die Anode der Diode D41 mit dem Signaleingang des integrierten Halbleiterschalters IC1 verbunden ist.

Um den elektronischen Schalter 400 einzuschalten, wird der Steuereingang S durch ein externes Steuergerät auf Masse gelegt. Hierdurch wird über die Diode D41 auch der Anschluss IN/GND des integrierten Halbleiterschalters IC1 nahezu auf Masse gezogen. Durch die nun zwischen den Anschlüssen VCC und IN/GND liegende Spannung wird der integrierte Halbleiterschalter versorgt, und er schaltet sich ein. Der Kondensator C1 ist jetzt auf die zwischen den Anschlüssen VCC und IN/GND liegende Spannung aufgeladen. Fällt hervorgerufen durch einen Kurzschluss im Lastkreis die Spannung am Anschluss VCC rapide ab, so wird dieser Spannngsabfall über den Kondensator C1 zum Anschluss IN/GND übertragen. Da die Diode D41 den Anschluss IN/GND vom Steuereingang S entkoppelt, wird das Potential am Anschluss IN/GND entsprechend negativ. Die Steuerschaltung bleibt dadurch versorgt, obwohl das Potential am Anschluss VCC bis auf 0 V abgesunken sein kann. Die Kapazität von C1 bestimmt die max. mögliche Überbrückzeit. C1 wird im wesentlichen nur durch den Stromfluss in den Anschluss IN/GND hinein entladen.

Gemäß der dritten Ausführungsform wird daher in schaltungstechnisch besonders einfacher Weise sichergestellt, dass im Falle eines Kurzschlusses der Halbleiterschalter dauerhaft abgeschaltet wird, selbst wenn durch den Kurzschluss ein vorübergehender Spannungszusammenbruch ausgelöst wird. Ein periodisches Wiedereinschalten "in den Kurzschluss hinein" wird zuverlässig verhindert, die thermische Belastung des integrierten Halbleiterschalters verringert und die Lebensdauer dementsprechend verlängert.

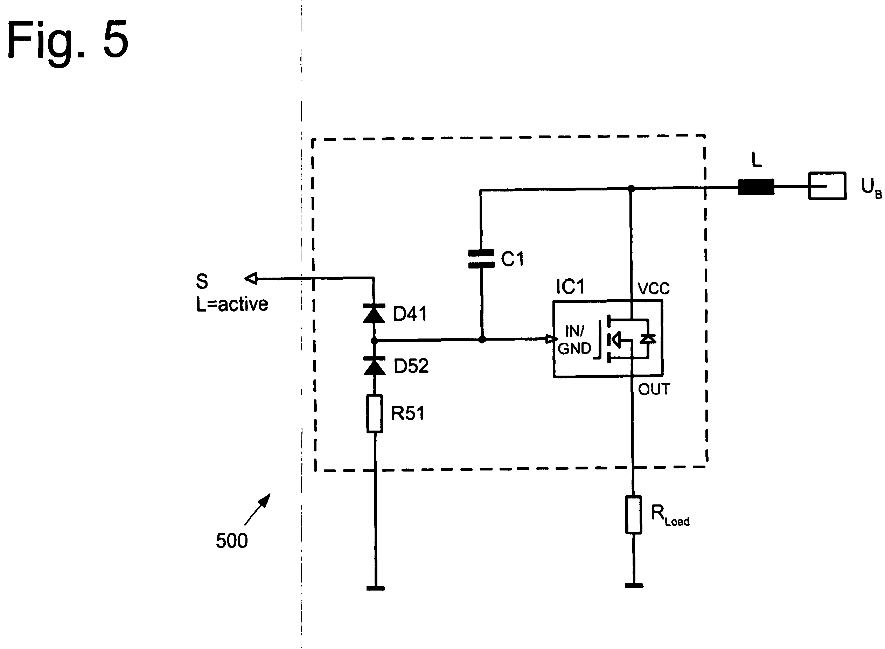

Die oben beschriebenen Ausführungsformen der vorliegenden Erfindung haben allerdings den Nachteil, das der meist in den Halbleiterschaltern implementierte Schutz vor Verpolung (Reverse-Battery-Schutz) außer Funktion gesetzt wird. Dieser Nachteil kann aber, wie beispielhaft in Fig. 5 gezeigt wird, durch eine zusätzliche Beschaltung vermieden werden. Diese zusätzliche Beschaltung kann auch bei den anderen Ausführungsformen eingesetzt werden, um dort den gleichen Vorteil zu erzielen.

Fig. 5 ist ein Schaltungsdiagramm für einen elektronischen Schalter 500 gemäß einer vierten Ausführungsform der vorliegenden Erfindung. Die vierte Ausführungsform ähnelt der in Fig. 4 gezeigten dritten Ausführungsform, wobei äquivalente Komponenten mit den gleichen Bezugszeichen gekennzeichnet sind und auf eine Wiederholung der entsprechenden Erläuterung verzichtet wird.

Die vierte Ausführungsform unterscheidet sich von der dritten Ausführungsform lediglich dadurch, dass der Steuereingang IN/GND des integrierten Halbleiterschalters IC1 durch eine Reihenschaltung einer in Sperrrichtung betriebenen Diode D52 und eines Widerstands R51 mit Masse verbunden ist. Bei korrekter Polung der Versorgungsspannung $U_B$ sperrt die Diode D52 im Normalbetrieb. Die Funktionsweise des elektronischen Schalters 500 unterscheidet sich daher nicht von der des elektronischen Schalters der dritten Ausführungsform. Lediglich im Falle eines Kurzschlusses, wenn das Potential des Steuereingangs des integrierten Halbleiterschalters auf einen Wert unterhalb des Massepotentials gezogen wird, wird die Diode D52 leitend, so dass sich der Kondensator außer über den Strom in den Steuereingang IN/GND hinein auch über die Diode D52 und den Widerstand R51 entlädt.

Der Widerstand R51 ist daher möglichst hochohmig zu wählen, damit der Entladestrom von C1 durch R51 und D52 möglichst gering bleibt. Der im Datenblatt des Herstellers angegeben maximal Wert darf aber auch nicht überschritten werden, da sonst der Reverse Battery Schutz nicht zuverlässig arbeitet. Typischerweise wird für R51 ein Wert von 510 Ohm bis 10kOhm vorgesehen werden.

Der Wert für C1 ist von dem Stromfluss in den Anschluss IN/GND des integrierten Halbleiterschalters, der Wahl von R51, der Stromänderungsgeschwindigkeit di / dt (diese wird durch den Überstrom und die Leitungsinduktivität bestimmt) und der RESET-Abschaltschwelle abhängig. Typische Werte liegen im Bereich 100nF bis 1μF. Der Wert ist so zu bestimmen, dass bei kleinster Versorgungsspannung, höchstem Spannungswert für LOW-Pegel am Steuereingang und größter Leitungsinduktivität die Spannung zwischen den Anschlüssen IN/GND und OUT nicht die RESET-Abschaltschwelle erreicht.

Tritt jetzt ein Kurzschluss zweiter Art (Kurzschluss, nachdem der Transistor bereits eingeschaltet war) oder erster Art (Einschalten in den Kurzschluss hinein) auf, so wird trotz Spannungseinbruch hervorgerufen durch den induktiven Spannungsabfall in der Zuleitungsinduktivität der Kurzschluss sicher erkannt und gespeichert. Der Schalter verriegelt sich selbst und kann erst durch ein definiertes Wegnehmen des Einschaltsignals am Anschluss IN/GND wieder zurückgesetzt werden. Danach lässt sich der Transistor durch ein entsprechendes Steuersignal am Signaleingang S wieder einschalten.

Außerdem wird auch bei einer Verpolung der Betriebsspannung die Stromversorgung der integrierten Steuer- und Überwachungsschaltung des Halbleiterschalters IC1 über die Diode D52 sichergestellt, so dass die Reverse-Battery-Funktionalität erhalten bleibt.

Die oben beschriebenen Ausführungsformen wurden im Zusammenhang mit integrierten Halbleiterschaltern beschrieben, die sich durch einen LOW-aktiven Signaleingang auszeichnen. Die vorliegende Erfindung ist aber nicht auf derartige Halbleiterschalter beschränkt, sondern kann ebenso auf integrierte Halbleiterschalter mit HIGH-aktivem Signaleingang angewendet werden, oder allgemeiner auf Halbleiterschalter mit dediziertem Masseanschluss zur Versorgung der integrierten Steuer- und Überwachungsschaltung.

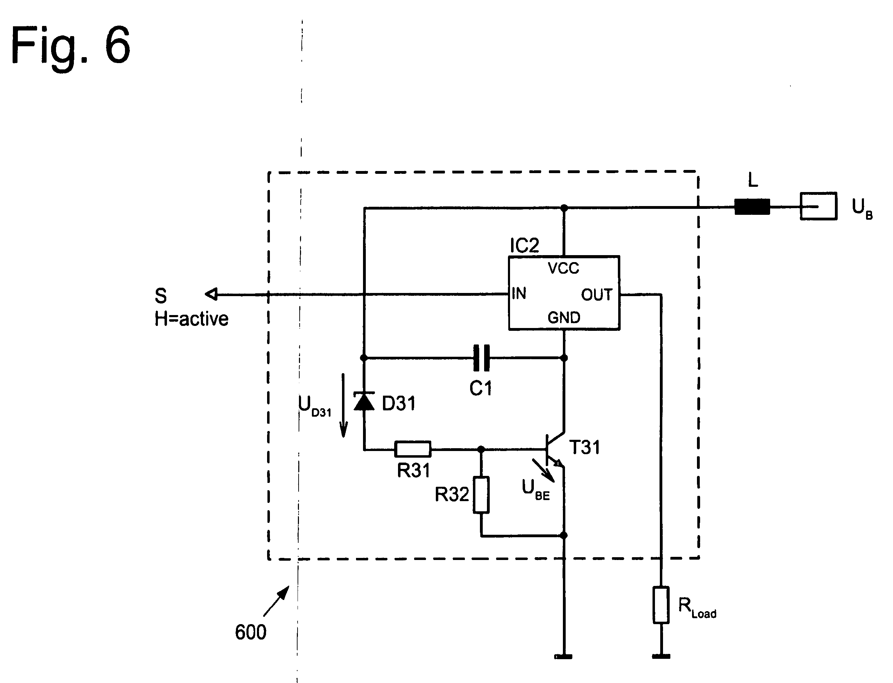

Fig. 6 ist ein Schaltungsdiagramm für einen elektronischen Schalter 600 gemäß einer fünften Ausführungsform der vorliegenden Erfindung. Die fünfte Ausführungsform ähnelt der in Fig. 3 gezeigten zweiten Ausführungsform, wobei äquivalente Komponenten mit den gleichen Bezugszeichen gekennzeichnet sind und auf eine Wiederholung der entsprechenden Erläuterung verzichtet wird.

Die fünfte Ausführungsform unterscheidet sich von der in Fig. 3 gezeigten zweiten Ausführungsform lediglich darin, dass der integrierte Halbleiterschalter IC2 über einen dedizierten Masseanschluss zur Versorgung der integrierten Steuer- und Überwachungsschaltung verfügt und der Stützkondensator C1 dementsprechend zwischen dem Betriebsspannungsanschluss VCC und dem Masseanschluss GND des integrierten Halbleiterschalters vorgesehen ist. Außerdem verbindet die zusätzliche Beschaltung mit dem Transistor T31 nicht den Steuereingang IN des integrierten Halbleiterschalters mit dem Steuereingang S des elektronischen Schalters, sondern den dedizierten Masseanschluss GND des integrierten Halb leiterschalters IC2 mit Masse.

Da, wie oben bereits erwähnt wurde, der LOW-aktive Steuereingang zum Einschalten des Halbleiterschalters auf Masse gelegt werden muss und somit zugleich dem Masseanschluss der integrierten Steuer- und Überwachungsschaltung entspricht, unterscheidet sich die Funktionsweise der fünften Ausführungsform nicht wesentlich von der der zweiten Ausführungsform.

In Figur 6 ist der Transistor T31, angesteuert durch R31 und D31, normalerweise immer durchgesteuert. Der Basisstrom und damit die zum Durchsteuern von T1 erforderliche Basis-Emitter-Spannung wird durch R31 und D31 aus der Versorgungsspannung $U_B$ erzeugt. Der Kondensator C1 lädt sich auf die Spannung am Anschluss VCC auf, da der untere Anschluss von C1 bei durchgeschaltetem T31 auf Masse-Potential liegt.

Zum Einschalten des Halbleiterschalters wird mit dem Steuersignal S der Steuersignaleingang IN des Halbleiterschalters auf HIGH-Pegel gelegt.

Sinkt nun, beispielsweise ausgelöst durch einen Kurzschluss die Spannung am Betriebsspannungsanschluss VCC des integrierten Halbleiterschalters IC2 bis auf Masse-Potential, also 0 V, ab, so sperrt der Transistor T31, sobald die Spannung am Anschluss VCC unter eine Spannung von etwa ( $U_{D31}$ + $U_{BE}$) abgesunken ist.

Der Kondensator C1 ist zum Zeitpunkt des Abschaltens von T1 auf die Spannung ( $U_{D31}$ + $U_{BE}$ ) aufgeladen und hält somit die Spannung zwischen den Anschlüssen VCC und GND auf diesem Wert, da der Masseanschluss GND des integrierten Halbleiterschalters IC2 durch den gesperrten Transistor T31 nicht mehr mit Masse verbunden ist. Diese Spannung reicht aus, um die interne Steuerschaltung des Halbleiterschalters zu versorgen.

Wurde der Spannungseinbruch durch einen Kurzschluss im Lastkreis des Halbleiterschalters hervorgerufen, so bleibt der als erstes erkannte Zustand "Kurzschluss" gespeichert und ein Wiedereinschalten des Halbleiterschalters nach dem Spannungseinbruch wird verhindert.

Der Kondensator C1 wird durch den Betriebsstrom des Halbleiterschalters entladen; infolge dessen sinkt die Spannung des Kondensators und damit die Spannung an den Anschlüssen VCC und GND ab. Wie in den anderen Ausführungsformen mit Ausnahme der ersten Ausführungsform ist die Stromversorgung des integrierten Halbleiterschalters daher nur während kurzzeitiger Spannungseinbrüche, hervorgerufen durch einen Kurzschluss in Verbindung mit der Leitungsinduktivität, sichergestellt, was aber in vielen Anwendungen ausreichend ist.

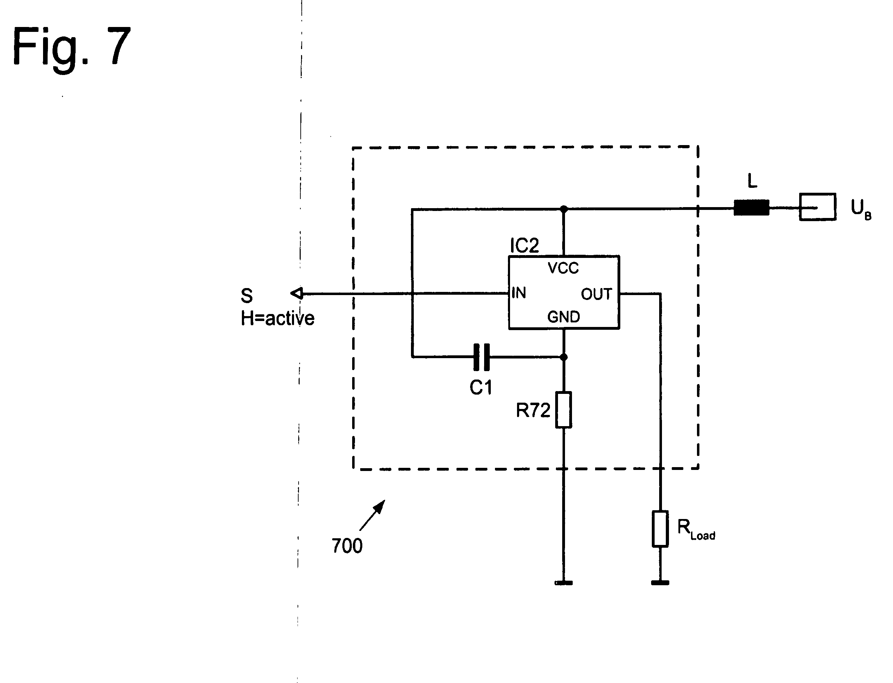

Fig. 7 ist ein Schaltungsdiagramm für einen elektronischen Schalter 700 gemäß einer sechsten Ausführungsform der vorliegenden Erfindung. Die sechste Ausführungsform ähnelt der in Fig. 6 gezeigten fünften Ausführungsform, wobei äquivalente Komponenten mit den gleichen Bezugszeichen gekennzeichnet sind und auf eine Wiederholung der entsprechenden Erläuterung verzichtet wird.

Die sechste Ausführungsform unterscheidet sich von der in Fig. 6 gezeigten fünften Ausführungsform lediglich darin, dass die Zusatzbeschaltung, die den Masseanschluss des integrierten Halbleiterschalters IC2 mit Masse verbindet, durch einen einfachen Ohmschen Widerstand ersetzt wurde. Dadurch ergibt sich ein besonders einfacher Schaltungsaufbau, der zugleich den Vorteil besitzt, dass die Reverse-Battery-Funktionalität erhalten bleibt und die Ruhestromaufnahme nicht erhöht wird.

Wie oben beschrieben wird der negative Spannungseinbruch im Falle eines Kurzschlusses über C1 vom Anschluss VCC zum Anschluss GND gekoppelt. In einer anderen Betrachtungsweise könnte man auch sagen, C1 überbrückt den Versorgungsspannungseinbruch zwischen den Anschlüssen VCC und GND des Bausteins, wobei der Widerstand R72 aber in entscheidender Weise dafür sorgt, dass der Masseanschluss des integrierten Halbleiterschalters IC2 auch auf einem Potential unterhalb des Massepotentials zu liegen kommen kann.

Der Stützkondensator C1 wird durch den Widerstand R72 und den Betriebsstrom des Bausteines IC2 entladen. Der Wert für C1 ist daher von dem Betriebsstrom des integrierten Halbleiterschalters, der Wahl von R1, der Stromänderungsgeschwindigkeit di / dt (diese wird durch den Überstrom und die Leitungsinduktivität bestimmt) und der RESET-Abschaltschwelle abhängig. Typische Werte liegen im Bereich 100nF bis 1µF. Der Wert ist so zu bestimmen, dass bei kleinster Versorgungsspannung und größter Leitungsinduktivität die Spannung zwischen den Anschlüssen VCC und GND nicht die RESET-Abschaltschwelle erreicht.

Auf diese Weise wird sichergestellt, dass die interne Steuerschaltung und insbesondere das interne Speicherelement des integrierten Halbleiterschalters IC2 ohne Unterbrechung mit Strom versorgt wird. Wurde der Spannungseinbruch durch einen Kurzschluss im Lastkreis des Halbleiterschalters hervorgerufen, so bleibt der als erstes erkannte Zustand "Kurzschluss" gespeichert und ein Wiedereinschalten des Halbleiterschalters nach dem Spannungseinbruch wird verhindert.

Im Falle eines Kurzschlusses wird der erfindungsgemäße Halbleiterschalter daher dauerhaft abgeschaltet, selbst wenn durch den Kurzschluss ein vorübergehender Spannungszusammenbruch ausgelöst wird. Ein periodisches Wiedereinschalten "in den Kurzschluss hinein" wird zuverlässig verhindert, die thermische Belastung des integrierten Halbleiterschalters verringert und die Lebensdauer dementsprechend verlängert. Gemäß der sechsten Ausführungsform der vorliegenden Erfindung werden diese Vorteile mit einer besonders einfachen Zusatzbeschaltung erreicht.

Mit der vorliegenden Erfindung wird also eine einfache Zusatzbeschaltung für selbstschützende integrierte Halbleiterschalter angegeben, die dafür sorgt, dass der Halbleiterschalter im Falle eines Kurzschlusses zuverlässig abgeschaltet bleibt, selbst wenn durch den Kurzschluss die Versorgungsspannung am Halbleiterschalter vorübergehend zusammenbricht. Erfindungsgemäß wird dies dadurch erreicht, dass das Potential des Masseanschlusses des integrierten Halbleiterschalters im Kurzschlussfall auf einen Wert unterhalb des Massepotentials gezogen wird, um so sicherzustellen, dass zwischen dem Betriebsspannungsanschluss und dem Masseanschluss eine Spannung anliegt, die ausreicht, um den Zustand "Überstrom/Kurzschluss" zu speichern und somit ein Wiedereinschalten zu verhindern.

**Patentansprüche**

1. Elektronischer Schalter mit
   einem integrierten Halbleiterschalterbaustein (IC1; IC2) zum Schalten des Laststroms eines zwischen einem Schaltausgang (OUT) des integrierten Halbleiterschalterbaustein (IC1; IC2) und Masse angeordneten elektrischen Gleichstromverbrauchers ($R_{Load}$), wobei der integrierte Halbleiterschalterbaustein (IC1; IC2) eine Überwachungsschaltung zur Detektion eines Kurzschlusses und eine Speichereinrichtung zur Speicherung des Detektionsergebnisses enthält,
   **gekennzeichnet durch**
   einen Steuersignaleingang (S), wobei der elektronische Schalter in Abhängigkeit von einem an dem Steuersignaleingang (S) angelegten Steuersignal und dem in der Speichereinrichtung gespeicherten Detektionsergebnis geöffnet und geschlossen wird,
   einen Kondensator (C1), der zwischen einem Betriebsspannungsanschluss (VCC) des integrierten Halbleiterschalterbausteins (IC1; IC2) und einem Masseanschluss (IN/GND; GND) des integrierten Halbleiterschalterbausteins (IC1; IC2) vorgesehen ist, und
   eine Zusatzbeschaltung (T31; D41; R72), die bei einem Einbruch der Spannung am Betriebsspannungsanschluss (VCC) des integrierten Halbleiterschalterbausteins (IC1; IC2) das Potential des Masseanschlusses (IN/GND; GND) des integrierten Halbleiterschalterbausteins (IC1; IC2) auf einen Wert unterhalb des Potentials der Masse zieht.

2. Elektronischer Schalter nach Anspruch 1, wobei die Zusatzbeschaltung (T31; D41; R72) den Masseanschluss (GND) des integrierten Halbleiterschalters mit Masse verbindet.

3. Elektronischer Schalter nach Anspruch 1, wobei die Zusatzbeschaltung (T31; D41; R72) den Masseanschluss (IN/GND) des integrierten Halbleiterschalters mit dem Steuersignaleingang (S) des elektronischen Schalters verbindet.

4. Elektronischer Schalter nach einem der Ansprüche 1 bis 3, wobei die Zusatzbeschaltung (T31; D41; R72) so ausgelegt ist, dass der Spannungsabfall über die Zusatzbeschaltung (T31; D41; R72) im Normalbetrieb im Wesentlichen 0 Volt beträgt.

5. Elektronischer Schalter nach einem der Ansprüche 1 bis 4, wobei die Zusatzbeschaltung (T31; D41; R72) so ausgelegt ist, dass der Spannungsabfall über die Zusatzbeschaltung (T31; D41; R72) bei einem Einbruch der Spannung am Betriebsspannungsanschluss (VCC) des integrierten Halbleiterschalterbausteins (IC1; IC2) im Wesentlichen der Betriebsspannung im Normalbetrieb entspricht.

6. Elektronischer Schalter nach einem der Ansprüche 1 bis 5, wobei die Zusatzbeschaltung (T31; D41; R72) durch einen Ohmschen Widerstand (R72) gebildet wird.

7. Elektronischer Schalter nach einem der Ansprüche 1 bis 5, wobei die Zusatzbeschaltung (T31; D41; R72) durch eine im Normalbetrieb in Durchlassrichtung geschaltete Diode (D41) gebildet wird.

8. Elektronischer Schalter nach einem der Ansprüche 1 bis 5, wobei die Zusatzbeschaltung (T31; D41; R72) durch einen Transistor (T31) gebildet wird, der im Normalbetrieb durchgesteuert ist und bei einem Einbruch der Spannung am Betriebsspannungsanschluss (VCC) sperrt.

**9.** Elektronischer Schalter nach einem der Ansprüche 1 bis 8, wobei der integrierte Halbleiterschalterbaustein zusätzlich eine Schutzschaltung gegen Verpolung enthält und der Masseanschluss (IN/GND; GND) des integrierten Halbleiterschalterbausteins (IC1; IC2) zusätzlich über eine Reihenschaltung aus einem Ohmschen Widerstand (R51) und einer im Normalbetrieb in Sperrrichtung geschalteten Diode (D52) mit Masse verbunden ist.

**10.** Kraftfahrzeugbordnetz mit einer Stromquelle ($U_B$), einem mit der Stromquelle ($U_B$) verbundenen Kabelbaum (L) und einem elektrischen Verbraucher ($R_{Load}$), wobei der elektrische Verbraucher ($R_{Load}$) über einen elektronischen Schalter (200; 300; 400; 500; 600; 700) nach einem der Ansprüche 1 bis 9 an einem bezüglich der Stromquelle ($U_B$) entgegengesetzten Ende des Kabelbaums (L) angeschlossen ist.

**Claims**

**1.** An electronic switch comprising
an integrated semiconductor switching device (IC1; IC2) for switching a load current of an electric DC load ($R_{Load}$) arranged between a switched output terminal (OUT) of the integrated semiconductor switching device (IC1; IC2) and ground, the integrated semiconductor switching device (IC1; IC2) comprising a monitoring circuit for detecting a short circuit and a memory means for storing a result of the detecting,
**characterised by**
a control signal input (S), the electronic switch being opened and closed in accordance with a control signal applied to the control signal input (S) and the result stored in the memory means;
a capacitor (C1) arranged between a power supply terminal (VCC) of the integrated semiconductor switching device (IC1; IC2) and a ground terminal (IN/GND; GND) of the integrated semiconductor switching device (IC1; IC2); and
an auxiliary circuitry (T31; D41; R72) which pulls the potential of the ground terminal (IN/GND; GND) of the intergrated semiconductor switching device (IC1; IC2) to a value below the ground potential in case of a drop of the voltage at the power supply terminal (VCC) of the integrated semiconductor switching device (IC1; IC2)

**2.** The electronic switch according to claim 1, wherein the auxiliary circuitry (T31; D41; R72) couples the ground terminal (GND) of the integrated semiconductor switch to ground.

**3.** The electronic switch according to claim 1, wherein the auxiliary circuitry (T31; D41; R72) couples the ground terminal (IN/GND) of the integrated semiconductor switch to the control signal input (S) of the electronic switch.

**4.** The electronic switch according to any of claims 1 to 3, wherein the auxiliary circuitry (T31; D41; R72) is configured such that a voltage drop across the auxiliary circuitry (T31; D41; R72) is substantially equal to zero volt during normal operation.

**5.** The electronic switch according to any of claims 1 to 4, wherein the auxiliary circuitry (T31; D41; R72) is configured such that the voltage drop across the auxiliary circuitry (T31; D41; R72) during a drop of the voltage at the supply voltage terminal (VCC) of the integrated semiconductor switching device (IC1; IC2) corresponds substantially to the supply voltage during normal operation.

**6.** The electronic switch according to any of claims 1 to 5, wherein the auxiliary circuitry (T31; D41; R72) is formed by an ohmic resistor (R72).

**7.** The electronic switch according to any of claims 1 to 5, wherein the auxiliary circuitry (D31; D41; R72) is formed by a diode (D41) connected in conducting direction in normal operation.

**8.** The electronic switch according to any of claims 1 to 5, wherein the auxiliary circuitry (D31; D41; R72) is formed by a transistor (T31) that is ON during normal operation and OFF during a drop of the voltage at the supply voltage terminal (VCC).

**9.** The electronic switch according to any of claims 1 to 8, wherein the integrated semiconductor switching device further comprises a protection circuit against voltage reversal and wherein the ground terminal (IN/GND; GND) of the integrated semiconductor switching device (IC1; IC2) is further connected to ground via a series connection of an ohmic resistor (R51) and a diode (D52) connected in reverse direction in normal operation.

**10.** A vehicle electrical system comprising a power supply ($U_B$), a wiring harness (L) connected to to the power supply

($U_B$), and an electric load ($R_{load}$), wherein the electric load ($R_{load}$) is connected to a remote end of the wiring harness (L) relative to the power supply ($U_B$) by means of an electric switch (200; 300; 400; 500; 600; 700) according to any of claims 1 to 9.

**Revendications**

1. Commutateur électronique comportant
   un composant de commutation semi-conducteur intégré (IC1 ; IC2) pour commuter le courant de service d'une charge de courant électrique continu ($R_{Load}$) agencée entre une sortie de commutation (OUT) du composant de commutation semi-conducteur intégré (IC1 ; IC2) et la terre, dans lequel le composant de commutation semi-conducteur intégré (IC1; IC2) comprend un circuit de surveillance de détection de court-circuit et un dispositif de stockage du résultat de détection,
   **caractérisé par**
   une entrée de signal de commande (S), dans lequel le commutateur électronique est ouvert et fermé en fonction d'un signal de commande appliqué à l'entrée du signal de commande (S) et du résultat de détection stocké dans le dispositif de stockage,
   un condensateur ($C_1$) agencé entre une connexion de tension de service (VCC) du composant de commutation semi-conducteur intégré (IC1 ; IC2) et une connexion de terre (IN/GND ; GND) du composant de commutation semi-conducteur intégré (IC1 ; IC2), et
   un circuit additionnel (T31 ; D41 ; R72) qui abaisse le potentiel de la connexion de terre (IN/GND ; GND) du composant de commutation semi-conducteur intégré (IC1 ; IC2) jusqu'à une valeur inférieure au potentiel de terre lors d'un creux de tension à la connexion de tension de service (VCC) du composant de commutation semi-conducteur intégré (IC1 ; IC2).

2. Commutateur électronique selon la revendication 1, dans lequel le circuit additionnel (T31 ; D41 ; R72) connecte la connexion de terre (GND) du commutateur semi-conducteur intégré à la masse.

3. Commutateur électronique selon la revendication 1, dans lequel le circuit additionnel (T31 ; D41 ; R72) connecte la connexion de terre (IN/GND) du commutateur semi-conducteur intégré à l'entrée du signal de commande (S) du commutateur électronique.

4. Commutateur électronique selon l'une des revendications 1 à 3, dans lequel le circuit additionnel (T31 ; D41 ; R72) est agencé de telle sorte que la chute de tension sur le circuit additionnel (T31 ; D41 ; R72) est essentiellement égale à 0 volt en service normal.

5. Commutateur électronique selon l'une des revendications 1 à 4, dans lequel le circuit additionnel (T31 ; D41 ; R72) est agencé de telle sorte que la chute de tension sur le circuit additionnel (T31 ; D41 ; R72) lors d'un creux de tension sur la connexion de tension de service (VCC) du composant de commutation semi-conducteur intégré (IC1 ; IC2) correspond essentiellement à la tension de service en service normal.

6. Commutateur électronique selon l'une des revendications 1 à 5, dans lequel le circuit additionnel (T31 ; D41 ; R72) est constitué par une résistance ohmique (R72).

7. Commutateur électronique selon l'une des revendications 1 à 5, dans lequel le circuit additionnel (T31 ; D41 ; R72) est constitué par une diode (D41) montée en sens passant en service normal.

8. Commutateur électronique selon l'une des revendications 1 à 5, dans lequel le circuit additionnel (T31 ; D41 ; R72) est constitué par un transistor (T31) qui est commandé en ouverture en service normal et en coupure lors d'un creux de tension sur la connexion de tension de service (VCC).

9. Commutateur électronique selon l'une des revendications 1 à 8, dans lequel le composant de commutation semi-conducteur intégré comporte en outre un circuit de protection contre une erreur de polarité, et la connexion de terre (IN/GND ; GND) du composant de commutation semi-conducteur intégré (IC1 ; IC2) est en outre connectée à la masse via un circuit en série constitué par une résistance ohmique (R51) et une diode (D52) montée en sens bloquant en service normal.

10. Alimentation embarquée pour véhicule automobile comportant une source de courant ($U_B$), un faisceau de câblage (L) connecté à la source de courant ($U_B$) et une charge électrique ($R_{Load}$), dans laquelle la charge électrique ($R_{Load}$) est connectée via un commutateur électronique (200 ; 300 ; 400 ; 500 ; 600 ; 700) selon l'une des revendications 1 à 9 à une extrémité du faisceau de câblage (L) opposée à celle de la source de courant ($U_B$).

# Fig. 1

# Fig. 2

EP 2 131 497 B1

# Fig. 3

EP 2 131 497 B1

Fig. 4

# Fig. 5

EP 2 131 497 B1

# Fig. 6

# Fig. 7

EP 2 131 497 B1

## EP 2 131 497 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0599455 A2
- EP 1176685 A1
- US 20040207967 A